# DEMANDE DE BREVET EUROPEEN

(11) **EP 2 043 173 A1**
(43) Date de publication de la demande: **01.04.2009**
(21) Numéro de dépôt: 08290848.4
(22) Date de dépôt: 10.09.2008
(51) Int. Cl.: H01L 51/05, H01L 51/30

(54) **Matrices hybrides pour tansistors à couches minces**

(30) Priorité: 27.09.2007 FR 0706767
(71) Demandeur: Commissariat A L'Energie Atomique - CEA, 75015 Paris (FR)
(72) Inventeur: Simonato, Jean-Pierre, 38360 Sassenage (FR); Celle, Caroline, 42700 Firminy (FR)
(74) Mandataire: Noel, Chantal Odile

(57) **Abrégé**

L'invention concerne un matériau hybride semi-conducteur ainsi qu'un dispositif le contenant.

Le matériau hybride semi-conducteur de l'invention comprend une matrice organique semi-conductrice dans laquelle des nano-objets semiconducteurs greffés par des entités organiques sont dispersés, la matrice organique comprenant de petites molécules semi-conductrices et lesdites entités organiques ayant une fonction électrique active similaire à celles desdites petites molécules semi-conductrices.

Le matériau hybride semi-conducteur de l'invention trouve application dans le domaine de l'électronique grande surface, en particulier.

## Description

L'invention concerne un matériau hybride semi-conducteur ainsi qu'un dispositif le contenant.

Les dispositifs à base de matériau semi-conducteur sont très utilisés ; ils commencent à l'être dans le domaine de l'électronique grande surface, où il faut produire des fonctions logiques simples avec un procédé peu coûteux.

Un des composants élémentaires de ces dispositifs est le transistor.

Pour produire un transistor, la partie semi-conductrice peut être produite par différents procédés.

Un de ces procédés est le dépôt en phase vapeur d'un matériau semi-conducteur. Mais ce procédé est difficile à mettre en oeuvre à grande échelle car il nécessite un vide poussé, de petites surfaces, etc.

Un autre procédé actuellement utilisé pour fabriquer la partie semi-conductrice des transistors est le dépôt en voie humide, dans lequel on utilise des solutions.

C'est ce procédé qui est privilégié actuellement car le dépôt peut alors être effectué à basse température, à pression ambiante et sur de grandes surfaces au moyen de techniques d'impression classiques telles que le jet d'encre, la flexographie, l'héliographie, etc.

Dans leur très grande majorité, les matériaux semi-conducteurs pour réaliser des transistors en couches minces pour grandes surfaces sont de structure chimique purement organique, c'est-à-dire composés de molécules hydrocarbonées, conjuguées, éventuellement substituées par tout élément du tableau de Mendeleïev, et/ou cyclisées.

Mais ces composés organiques présentent des performances médiocres qu'il convient d'améliorer pour une application à grande échelle. Par exemple, les mobilités des porteurs de charges de ces matériaux organiques ne permettent pas d'obtenir des dispositifs performants et rapides.

D'autres matériaux semi-conducteurs sont constitués de matériaux inorganiques de très petites tailles, appelés nano-objets, aux propriétés semi-conductrices appropriées.

Un nano-objet est défini comme une entité dont au moins deux des trois dimensions dans l'espace sont inférieures à 100 nanomètres.

Un matériau inorganique représentatif est le nanotube de carbone.

Cependant, la purification des nanotubes de carbone est très difficile et à l'heure actuelle des nanotubes de carbone purs semi-conducteurs ne sont pas disponibles.

Ainsi, les matériaux inorganiques semi-conducteurs de ce type sont toujours des mélanges de nanotubes de type semi-conducteur et de type métallique, ce qui rend leur procédé de fabrication complexe. De plus, ces matériaux manquent de reproductibilité pour un usage à grande échelle.

On a alors proposé de fonctionnaliser des nanotubes de carbone de façon non covalente par un surfactant et de les disperser dans une matrice polymère de type polyhexylthiophène. Cependant, bien qu'un gain de mobilité soit obtenu grâce à l'addition de nanotubes de carbone, il apparaît que dans le même temps le rapport Ion/loff du transistor fabriqué à partir de ce matériau devient insuffisant pour une application industrielle, ce rapport caractérisant la capacité du transistor à passer de l'état "on" à l'état "off".

On a également proposé d'utiliser, en tant que matériau inorganique semi-conducteur, des nanofils de silicium, dopés ou non dopés. Ces nanofils peuvent être utilisés comme la partie semi-conductrice des transistors. Cependant, leur mise en oeuvre nécessite des techniques complexes, en inadéquation avec les techniques d'impression à bas coût pour grandes surfaces envisagées dans le cadre d'un procédé industriel.

Ces transistors à base de nanofils semi-conducteurs comprennent des nanofils qui sont mis en contact directement sur les électrodes de source et de drain, ce qui implique que la longueur des nanofils utilisés est au minimum celle de la distance minimale entre les électrodes source et drain. Ceci sort du cadre de la présente invention dans la mesure où nous nous plaçons dans le cadre de l'électronique grande surface où les distances source-drain peuvent atteindre quelques dizaines de micromètres (µm). Or, aujourd'hui des nanofils de cette dimension sont difficile à réaliser et à manipuler.

Par ailleurs, la demande de brevet US 2005/0104060 décrit des nanoparticules de silicium fonctionnalisées pour améliorer la mobilité des porteurs de charges dans une matrice semi-conductrice du type poly-3-hexylthiophène.

Dans cette demande de brevet, des groupements organiques simples, mais tous différents de l'unité constitutive du polymère constituant la matrice semi-conductrice, sont greffés de manière covalente à des nanoparticules semi-conductrices inorganiques.

Ces nanoparticules sont alors dispersées dans la matrice semi-conductrice et ainsi confèrent au matériau obtenu un léger gain de mobilité des porteurs de charges.

Cependant, les groupements organiques greffés ne possèdent pas de groupements susceptibles de réaliser des transferts de charges entre la partie semi-conductrice organique constituée par la matrice et les nanoparticules de silicium.

L'invention vise à pallier les inconvénients des matériaux semi-conducteurs de l'art antérieur en proposant un matériau semi-conducteur dans lequel la mobilité des porteurs de charges est améliorée, auquel des procédés de dépôt par voie humide selon les techniques classiques d'impression peuvent être appliqués.

Ainsi, l'invention propose de nouvelles matrices hybrides organiques, inorganiques, semi-conductrices et aux performances accrues par rapport à des matrices purement organiques.

A cet effet, l'invention propose un hybride semi-conducteur du type comprenant une matrice organique semi-conductrice dans laquelle des nano-objets semi-conducteurs greffés par des entités organiques sont dispersés, caractérisé en ce que ladite matrice organique comprend de petites molécules semi-conductrices et en ce que lesdites entités organiques greffées sur des nano-objets semi-conducteurs ont une fonction électrique active de structure similaire à celles desdites petites molécules semi-conductrices.

De préférence, lesdites entités ont également une fonction permettant le greffage covalent desdites entités organiques sur le nano-objet.

Dans une première variante de l'invention, les nano-objets sont des nanofils.

De préférence, les nanofils sont des nanofils de silicium.

Egalement de préférence, les nanofils sont des nanofils de germanium-silicium, Ge-Si.

Encore de préférence, les nanofils sont des nanofils d'oxyde de zinc, ZnO.

Toujours de préférence, les nanofils sont des nanofils d'arséniure de gallium, GaAs.

Dans une autre variante de l'invention, les nano-objets sont des nanotubes de carbone.

Dans tous les modes de réalisation de l'invention, lesdits nano-objets ont de préférence au moins deux dimensions inférieures à 100 nanomètres et un rapport longueur/diamètre supérieur à 10.

L'invention propose aussi un dispositif comprenant un matériau selon l'invention.

De préférence, ce dispositif est un transistor.

Les matériaux hybrides semi-conducteurs de l'invention sont réalisés par dispersion, dans des matrices organiques semi-conductrices, de nano-objets semi-conducteurs, dopés ou non, greffés par des entités organiques.

Les éléments de dopage des nano-objets présentant des doublets électroniques libres ou des lacunes sont, par exemple, des dérivés du bore, du phosphore, etc.

Les nano-objets peuvent être des nanofils d'oxyde de zinc, ZnO, d'arséniure de gallium, GaAs, de silicium, Si, de germanium, Ge, ou de germanium-silicium, si-Ge, ou des nanotubes de carbone.

Ces différents types de nano-objets peuvent être présents seuls ou en mélange de deux ou plus.

Les nano-objets de l'invention ont une longueur inférieure à la taille du canal entre les électrodes de source et de drain.

Les nano-objets de l'invention sont fonctionnalisés afin d'atteindre deux objectifs de façon concommitante : obtenir une dispersion satisfaisante des nano-objets dans la matrice organique et permettre un transfert de charges efficace entre les nano-objets et la matrice organique semi-conductrice.

Ainsi, les entités qui sont greffées sur les nano-objets sont de type bifonctionnelles : une partie, appelée ici groupe réactif ou groupement réactif, sert au greffage covalent sur le nano-objet et l'autre partie, appelée ici partie active électrique, sert à la compatibilisation avec la matrice hôte et au transfert de charges.

Pour obtenir le transfert de charges, les entités greffées sur les nano-objets de l'invention comportent des motifs susceptibles de réaliser le transfert de charges, tels que des liaisons pi, des électrons n, des orbitales d ou des espèces de type redox.

Pour obtenir la compatibilisation avec la matrice hôte, la partie active électrique de l'entité greffée est choisie en fonction de la matrice organique utilisée. La partie active sera dite similaire à la matrice organique, c'est-à-dire qu'elle possède le même squelette de base.

Pour une matrice constituée d'un polymère semi-conducteur, la fonction active utilisée est de structure similaire à celle du monomère du polymère semi-conducteur.

Pour tout système organique semi-conducteur à base de petites molécules, la fonction active sera de nature similaire aux petites molécules semi-conductrices présentes dans la matrice.

Au sens de l'invention, les termes « petites molécules semi-conductrices » signifient des molécules semi-conductrices organiques ayant un poids moléculaire inférieur ou égal à 1500g/mol.

A titre d'exemples illustratifs et non limitatifs, la fonction active électrique peut-être du type thiophènes et leurs dérivés, arylamines et leurs dérivés, isochroménones et leurs dérivés, pentacènes et leurs dérivés, porphyrines, phthalocyanines et leurs dérivés.

Le groupement réactif sera choisi en fonction des nano-objets.

Ainsi, dans le cas des nanofils de silicium, ceux-ci peuvent être recouverts d'une couche d'oxyde ou non. Ceci induit que les modes de fonctionnalisation ont à être choisis selon le type de nanofil utilisé.

Les nanofils de Si possédant une couche d'oxyde présentent en surface des fonctions réactives de type silanol, Si-OH, alors que les nanofils sans oxyde présentent essentiellement des fonctions de type hydrure de silicium, Si-H.

A titre d'exemples non limitatifs, les groupes réactifs utilisables pour les nanofils de silicium peuvent être les suivants :
- dans le cas des nanofils de silicium sans couche d'oxyde, c'est-à-dire ayant en surface des liaisons de type Si-H, on peut utiliser des sels de diazonium R-N₂⁺ + X⁻ ou des composés insaturés de types vinyliques ou acétyléniques.
- pour les nanofils de silicium ayant une couche d'oxyde, c'est-à-dire ayant en surface des liaisons de type Si-OH, le groupe réactif peut être un trihalogenosilane R-SiX₃ ou un trialcoxysilane de type R-Si(OR)₃.

Pour les nano-objets de type oxyde tels que en ZnO, le groupe réactif est choisi par exemple dans la famille des silanes.

Le greffage des entités organiques actives peut être obtenu en plusieurs étapes. Par exemple, il est possible de greffer une première partie organique sur les nano-objets avec un groupement réactif pendant et, ensuite, de fonctionnaliser ce groupement réactif pendant par une ou plusieurs réactions pour lier la fonction électrique active.

Les matériaux hybrides semi-conducteurs de l'invention peuvent être utilisés dans tout type de dispositifs nécessitant un dispositif semi-conducteur mais ils seront de préférence utilisés en tant que parties semi-conductrices de transistors à couches minces.

Par le greffage covalent d'entités organiques sur les nano-objets un double objectif est atteint.

D'une part, les nano-objets, dopés ou non, sont parfaitement dispersés dans la matrice semi-conductrice, ce qui confère au matériau semi-conducteur hybride ainsi formé la possibilité d'être appliqué par des techniques d'impression en voie humide. La présence des nano-objets confère au matériau semi-conducteur hybride de l'invention une amélioration substantielle des performances électriques et notamment de la mobilité des porteurs de charges.

D'autre part, la fonctionnalisation des nano-objets avec des groupements permettant des transferts de charges entre les nano-objets et la matrice organique permet une amélioration supplémentaire des performances électriques du matériau semi-conducteur hybride de l'invention.

Dans l'invention, les nano-objets sont fonctionnalisés avant leur dispersion dans la matrice organique semi-conductrice.

Le greffage des entités organiques se fait généralement lorsque les nano-objets sont liés à un substrat.

Dans l'invention, il est possible de décrocher les nano-objets du substrat après leur fonctionnalisation chimique réalisée alors qu'ils étaient sur le substrat et les disperser en solution.

On peut également les purifier et enlever le catalyseur résiduel et/ou la couche d'oxyde natif.

On peut fonctionnaliser chimiquement les parois du nano-objet selon différentes méthodes, telles que par greffage chimique sur l'oxyde de surface par des trihalogenosilanes ou trialcoxysilanes, par réactions de composés insaturés ou de sels de diazonium sur une surface de silicium dont l'oxyde a été préalablement enlevé.

La fonctionnalisation peut être réalisée en plusieurs étapes.

On peut également solubiliser les nanofils ainsi fonctionnalisés dans un composé organique et dès lors, on peut utiliser la solution ainsi obtenue en vue de fabriquer des transistors par un procédé de dépôt par voie humide.

Afin de mieux faire comprendre l'invention, on va maintenant en décrire, à titre purement illustratif et non limitatif, plusieurs exemples de mise en oeuvre.

### Exemple 1 : Fabrication d'un transistor à film en matériau hybride de type p à nanofils de silicium greffés avec un dérivé de triphénylamines.

### 1) Synthèse du dérivé de la TPA :

La 1-(4-(diphénylamino)phényl)-3-(3-(triéthoxysilyl)propyl)urée (dérivé de la TPA) est synthétisée en trois étapes à partir de la diphénylamine et du 4-fluoronitrobenzène, par formation de la *p*-nitro-triphenylamine, réduction du groupement nitro en amino et introduction de la fonction triéthoxysilane par addition de l'isocyanatopropyltriéthoxysilane sur la *p*-amino-triphenylamine au reflux dans l'éthanol sec. Le produit est obtenu sous la forme d'un solide brun par précipitation dans le pentane, filtration et séchage avec un rendement global de 37 %. 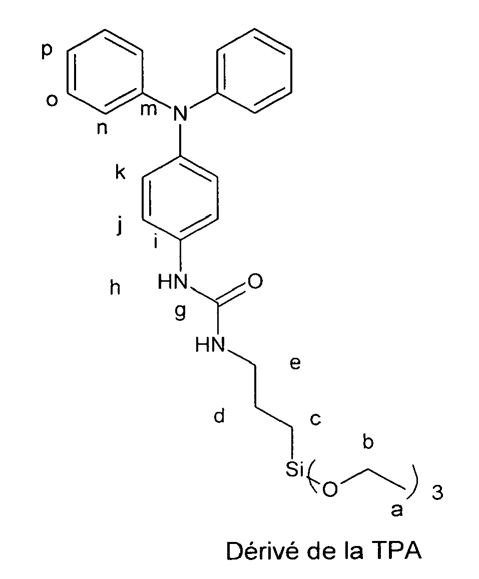 **RMN ¹H** (200 MH_{Z}, DMSO, 300 K) : δ (ppm) = 0,55 (t, 2H, ³*J* = 8,3 H_{Z}, H*_{c}*), 1,14 (t, 9H, ³*J* = 7,3 H_{Z}, H*ₐ*), 1,47 (p, 2H, ³*J* = 8,3 H_{Z}, H*_{d}*), 3,03 (t, 2H, ³*J* = 8,3 H_{Z}, H*ₑ*), 3,74 (q, 6H, ³*J* = 7,3 H_{Z}, H*_{b}*), 6,14 (s, 1 H, H*_{f}*), 6,94 (m, 8H, H*ₖ* + H*ₙ* + H*ₚ*), 7,28 (m, 6H, H*ⱼ* + H*ₒ*), 8,41 (s, 1 H, H*ₕ*).
RMN ¹³C{¹H} (200 MHZ, DMSO, 300 K) : δ (ppm) = 8,4 (C*_{c}*), 19,4 (C*ₐ*), 24,5 (C*_{d}*), 42,1 (Ce), 56,9 (C*_{b}*), 119,9 (C*ⱼ*), 122,7 (Cp), 123,3 (C*ₙ*), 127,1 (C*ₖ*), 130,2 (C*ₒ*), 137,8 (C*ⱼ*), 141,1 (C*ₗ*), 148,4 (C*ₘ*), 156,1 (Cg).
**MALDI-TOF :** m/z = 530,25 [M+Na]⁺, 316,16 [M-CH₂CH₂Si(OEt)_{3]}⁺.
**HRMS (EI) :** calc pour C₂₈H₃₇N₃NaO₄Si 530,24455, trouvé 530,24656, Err (ppm) - 3,79.
**IR (ATR, cm⁻¹) :** 3321 (v N-H), 3062 (ν C-H_{Ar}), 2973 (νₐₛ C-H), 2873 (νₛ C-H), 1641 (v C=O), 1597 et 1509 (ν C=C_{Ar}), 1565 (δ N-H), 1271 (v C-N), 1235 (v C-C), 1078 (νₐₛ Si-O-C), 957 (νₛ Si-O-C), 754 (γ C-H_{Ar}), 695 (γ cycle).
**UV/vis (EtOH) :** λₘₐₓ/nm (ε/L.mol⁻¹.cm⁻¹, transition) = 232 (14420, π→π^{*} E₂ band), 301 (25000, p→ π).

### 2) Greffage du dérivé de la TPA sur des nanofils de silicium :

Les nanofils de silicium dopés p (B/Si = 4.10⁻⁴), toujours portés par leur substrat de croissance (wafer de silicium 1 cm²), sont lavés avec de l'éthanol et de l'acétone puis la plaque est séchée à l'argon. Ces nanofils de silicium de type p possèdent une Longueur moyenne de 5µm et un diamètre moyen centré autour de 100nm.

La plaque est ensuite immergée dans une solution Piranha (H₂SO₄ : H₂O₂ 70/30) pendant 15 Min puis est rincée à l'eau déionisée et séchée à l'argon. Dans une seconde étape d'activation, cette plaque est exposée aux rayonnements UV sous ozone pendant 45 min puis elle est plongée dans une solution de 1-(4-(diphénylamino)phényl)-3-(3-(triéthoxysilyl)propyl)urée dans le toluène (10⁻³M) et cette dernière est chauffée à 80°C pendant 4 h sans agitation. Après refroidissement, la plaque est sortie puis rincée avec de l'éthanol et de l'acétone et est séchée à l'argon. Les nanofils ainsi fonctionnalisés sont dégreffés dans 1MI de toluène par sonication (puissance : 100 %) pendant 1 min.

### 3) Dispersion des nanofils de silicium fonctionnalisés par le dérivé de la TPA dans la matrice organique semi-conductrice α-NPD :

La matrice organique semi-conductrice (petites molécules) retenue dans cet exemple, pour disperser les nanofils de silicium fonctionnalisés par le dérivé de la TPA est le α-(naphtyl)phénylènediamine (α-NPD).

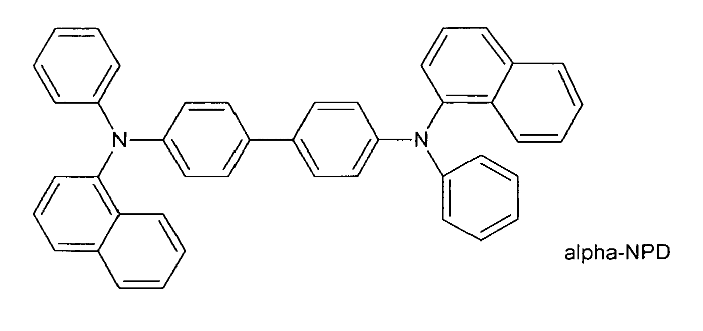

A une solution à 3mg/MI de α-NPD dans le toluène est ajoutée la suspension de nanofils de silicium (1% en poids de nanofils par rapport au α-NPD). Les caractérisations électriques en fonctionnement transistors ont été réalisées à l'aide d'embases de transistors grille basse et contact par-dessous.

Le film de semi-conducteur hybride (matrice organique à petites molécules α-NPD + nanofils de silicium fonctionnalisé par le dérivé de la TPA) est obtenu par évaporation lente en tension de vapeur saturante de la solution semi-conductrice hybride. Un recuit du semi-conducteur hybride est réalisé à 100°C pendant 20 minutes sous azote.

Les transistors ainsi testés (possédant un W/L de 1000) présentent des performances électriques améliorées avec des mobilités des porteurs de charges (trous) de 2,4.10⁻⁴ cm²/Vs et un rapport Ion/Ioff de 10₃. L'introduction de ces nanocharges fonctionnalisées dans la matrice organique semi-conductrice permet d'améliorer la mobilité d'un facteur 4 par rapport à la matrice seule, sans dégrader le rapport Ion/loff.

### Exemple 2 : Fabrication d'un transistor à film en matériau hybride de type n à nanofils de silicium greffés avec un dérivé de rylènes.

### 1) Synthèse et greffage du pérylène diimide dissymétrique sur les nanofils de silicium :

Le *N*-octyl-*N*'-acétylénylphénylpérylène-3,4,9,10-bis(dicarboximide) (PDI-8-acétylénylphényle) est synthétisé en trois étapes à partir du 3,4,9,10-pérylènetetracarboxylic dianhydride (PDA). Une des fonctions anhydride de ce dernier est ouverte par traitement dans la potasse à chaud puis de l'acide phosphorique est additionné jusqu'à 5,5 < pH < 6,5 pour obtenir le sel monopotassique du pérylène monoanhydride monoacide monocarboxylate. L'addition de 4 équivalents de N-octylamine permet d'obtenir après purification par traitement dans la potasse à chaud le N-octyl-3,4,9,10-pérylènetetracarboxylic acid-3,4-anhydride-9,10-imide (PAI-8). Enfin, la réaction de ce pérylène monoanhydride monoimide avec 4 équivalents d'éthynylaniline dans le toluène à reflux conduit à la formation, après purification sur colonne de silice avec comme éluant un mélange chloroforme / acide acétique 90 : 10, du produit désiré PDI-8-acétylénylphényle sous la forme d'un solide rouge avec un rendement global de 44 %. 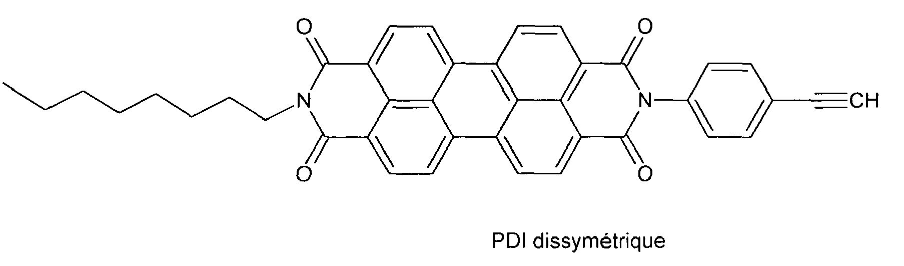 **RMN ¹H** (500 MH_{Z}, CDCl₃, 300 K) : δ (ppm) = 0,80 (t, 3H, CH₃), 1,32 (m, 10H, CH₂), 1,87 (m, 2H, NCH₂CH₂), 3,12 (s, 1 H, CH), 4,21 (t, 2H, NCH₂), 7,53 (d, 2H, ³*J* = 8,1 H_{Z}, CH*_{Ar}*), 7,78 (d, 2H, ³*J* = 8,1 H_{Z}, CH*_{Ar}*), 8,28 (d, 2H, ³*J* = 8,1 H_{Z}, CH_{peryene}), 8,39 (d, 2H, ³*J* = 8,4 Hz, CH_{perylene}), 8,48 (d, 2H, ³*J* = 8,4 Hz, CH_{peryene}), 8,60 (d, 2H, ³*J* = 8,1 H_{Z}, CH_{perylene}).
**RMN ¹³C**{¹H} (500 MHZ, CDCl₃, 300 K) : δ (ppm) = 14,1 (CH*₃*) ; 22,7 ; 26,7 ; 28,5 ; 29,3; 30,2 ; 31,8; 38,2 ; (7 C,CH₂) ; 81,4 (CH) ; 82,3 (C≡CH) ; 111,3 (CH*_{Ar}*) ; 118,3 (C*_{Ar}*) ; 124,5 ; 126,1 ; 126,7 ; 128,1 ; 128,4 ; 128,8 ; 129,2 ; 129,6 ; 130,4 ; 130,6 ; 130,9 ; 131,2 ; 135,2 ; 135,7 ; (23 C, C*_{Ar}* + CH*_{Ar}* + CH_{peryene} + C_{perylene}) ; 158,6 ; 159,3 (4 C, C=O).
**IR (ATR, cm⁻¹)** : 3267 (v C-H), 3062 (ν C-H_{Ar}), 2973 (νₐₛ C-H), 2873 (νₛ C-H), 2103 (v C≡CH), 1693 et 1652 (v C=O), 1597 et 1509 (ν C= C*_{Ar}*), 1271 (v C-N), 1235 (v C-C), 808 (γ C-H_{Ar}), 747 (γ cycle).

### 2) Greffage du pérylène diimide dissymétrique sur les nanofils de silicium :

Les nanofils de silicium dopés n (P/Si = 2.10⁻⁴), toujours portés par leur substrat de croissance (wafer de silicium 1 cm²), sont lavés avec de l'éthanol et de l'acétone puis la plaque est séchée à l'argon. Ces nanofils de silicium de type n possèdent une longueur moyenne de 4µm et un diamètre moyen centré autour de 100nm.

La plaque est ensuite immergée dans une solution diluée d'acide fluorhydrique (1 %) pendant 2 min puis est rincée à l'eau déionisée. Elle est alors plongée dans une solution de fluorure d'ammonium (40 %) pendant 2 min puis est rincée à l'eau déionisée et séchée à l'argon. Par la suite, elle est introduite dans un ballon équipé d'un réfrigérant contenant une solution de *N*-octyl-*N*'-acétylénylphénylpérylène-3,4,9,10-bis(dicarboximide) dans le mésithylène (10⁻³ M) et cette dernière est chauffée à 180°C pendant 2 h sous argon sans agitation. Après refroidissement, la plaque est sortie puis rincée avec de l'éthanol et de l'acétone et est séchée à l'argon. Les nanofils ainsi fonctionnalisés sont dégreffés dans 1 MI d'ODCB (orthodichlorobenzène) par sonication (puissance : 100 %) pendant 1 min.

### 3) Dispersion des nanofils de silicium fonctionnalisés par le pérylène diimide dissymétrique dans la matrice organique semi-conductrice PDI8-CN2 :

La matrice organique semi-conductrice de type n (petites molécules) retenue dans cet exemple, pour disperser les nanofils de silicium fonctionnalisés par le PDI dissymétrique est le pérylène diimide ci-dessous. 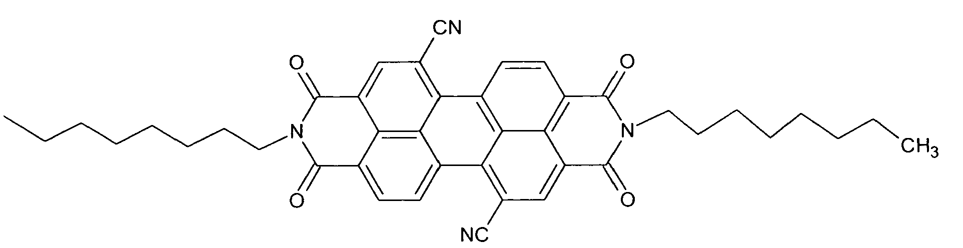 A une solution à 4 mg/MI de PDI8-CN2 dans l'ODCB est ajoutée la suspension de nanofils de silicium (1 % en poids de nanofils par rapport au α-NPD). Les caractérisations électriques en fonctionnement transistors ont été réalisées à l'aide d'embases de transistors grille basse et contact par-dessous.

Le film de semi-conducteur hybride (matrice organique à petites molécules PDI8-CN2 + nanofils de silicium fonctionnalisé par PDI dissymétrique) est obtenu par dépôt à la tournette. Un recuit du semi-conducteur hybride est réalisé à 100°C pendant 20 minutes sous azote.

Les transistors élaborés avec la matrice organique seule possèdent des mobilités de 1.10⁻³ cm²/Vs. Les transistors à semi-conducteur hybride (possédant un W/L de 1000) présentent des performances électriques améliorées avec des mobilités des porteurs de charges (électrons) de 5.10⁻³ cm²/Vs et un rapport Ion/loff de 10⁴. L'introduction des nanofils de Si dopés n fonctionnalisés dans la matrice organique semi-conductrice permet d'améliorer la mobilité d'un facteur 5 par rapport à la matrice seule, sans altérer le rapport Ion/loff.

## Revendications

1. Matériau hybride semi-conducteur du type comprenant une matrice organique semi-conductrice dans laquelle sont dispersés des nano-objets semi-conducteurs greffés par des entités organiques, **caractérisé en ce que** ladite matrice organique comprend de petites molécules semi-conductrices et **en ce que** lesdites entités organiques greffées sur des nano-objets semi-conducteurs ont une fonction électrique active de structure similaire à celle desdites petites molécules semi-conductrices.

2. Matériau selon la revendication 1, **caractérisé en ce que** lesdites entités organiques ont également une fonction permettant le greffage covalent desdites entités organiques sur le nano-objet.

3. Matériau selon la revendication 1 ou 2, **caractérisé en ce que** les nano-objets sont des nanofils.

4. Matériau selon la revendication 3, **caractérisé en ce que** les nanofils sont des nanofils de silicium.

5. Matériau selon la revendication 3, **caractérisé en ce que** les nanofils sont des nanofils de germanium-silicium.

6. Matériau selon la revendication 3, **caractérisé en ce que** les nanofils sont des nanofils d'oxyde de zinc, ZnO.

7. Matériau selon la revendication 3, **caractérisé en ce que** les nanofils sont des nanofils d'arséniure de gallium GaAs.

8. Matériau selon la revendication 1 ou 2, **caractérisé en ce que** les nano-objets sont des nanotubes de carbone.

9. Matériau selon la revendication 1 ou 2, **caractérisé en ce que** lesdits nano-objets ont au moins deux dimensions inférieures à 100 nanomètres et un rapport longueur/diamètre supérieur à 10.

10. Dispositif **caractérisé en ce qu'**il comprend un matériau selon l'une quelconque des revendications précédentes.

11. Dispositif selon la revendication 10, **caractérisé en ce qu'**il s'agit d'un transistor.
